# EUROPEAN PATENT APPLICATION

(11) **EP 0 521 720 A1**
(43) Date of publication of application: **07.01.1993**
(21) Application number: 92306113.9
(22) Date of filing: 02.07.1992
(51) Int. Cl.: H05K 1/05, H05K 3/44

(54) **Heat-dissipating multi-layer circuit board**

(30) Priority: 02.07.1991 US 724623
(71) Applicant: CHOMERICS, INC., Woburn Massachusetts 01888 (US)
(72) Inventor: DeSorgo, Miksa, Windham, New Hampshire 03087 (US); McGovern, James F., Atkinson, New Hampshire 03811 (US); Lionetta, William G., Jr., Winchester, Massachusetts 01890 (US)
(74) Representative: Barlow, Roy James

(57) **Abstract**

A multi-layer heat dissipating circuit board provides a thermally conductive base plate. An electrically insulating and thermally conductive base insulating layer is disposed over the base plate upon one face thereof. A plurality of alternating layers of electrically conductive leads (74,76,78) and selectively disposed insulation are deposited over the base plate and its base insulating layer with portions of the insulation between alternating layers of electrically conductive leads being exposed so that leads of upper layers (66) may be connected to leads of lower layers (60). The base plate may be constructed of aluminum while at least one of either the insulating or electrically conductive layers may be applied by means of silk screening of a liquid compound that is subsequently hardened.

## Description

### Field of the Invention

This invention relates to a multi-layer circuit board and more particularly to a circuit board having improved heat dissipation capabilities.

### Background of Invention

Printed circuit boards having multiple layers, each containing leads that may be interconnected to each other between layers for joining various semi-conductor components mounted upon the board have become more popular. As the number of components upon a board has increased while the size of the board has decreased, it has become ever more important to carefully plan interconnections of leads between components. For large logic arrays having a great number of pin connections, it is quite probable that leads will necessarily cross each other. Clearly, if all leads were located on the same power plane of the board, the circuit would become shorted.

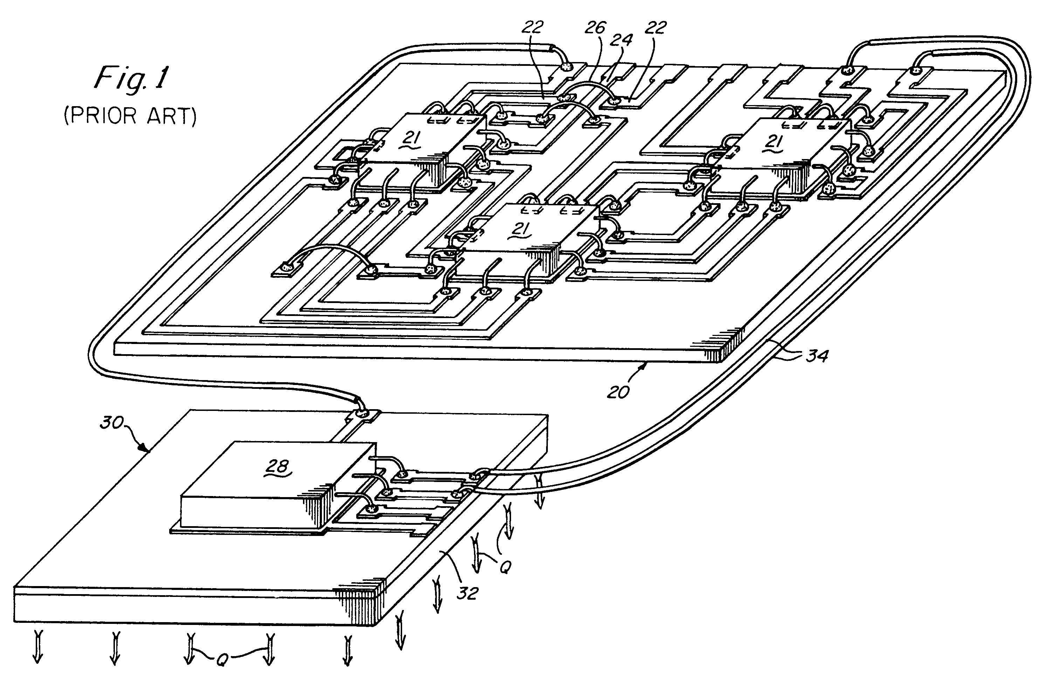

In the past, the problem of crossing leads in a large two dimensional circuit board 20 having a number of integrated circuit chips 21 thereon was addressed in a manner shown in FIG. 1, i.e. by breaking one of the two crossing leads 22 prior to its junction with the other lead 24 and providing an externally disposed jumper wire 26 that bridges the crossed lead 24 without electrical contact therebetween. However, as circuits have become increasingly more complex, jumpers have become too numerous and bulky, increasing the risk of failure. Thus, concern for reliability has dictated that a multi-layer "sandwich" approach, rather than jumper wires, be employed. As such, the now popular multi-layer boards generally provide a printed circuit base layer upon an insulated (epoxy glass) rigid board. The first (base) conductive printed circuit layer includes leads and pads for mounting various semi-conductor components. Leads that otherwise cross, are left broken before their potential crossing point and then a second layer of insulation is disposed over the board at all points except the very ends of the broken leads. A second conductive layer is located at selective points to bridge the unbroken leads between predetermined junctions. Additional layers of insulator and conductive material may be selectively applied, one atop the other, until all junctions are bridged and all connections between components are completed.

One advantage of the multi-layer system is its ability to allow extremely close packing of semi-conductor components onto a given surface of circuit board. This fact, combined with the general trend in the electronics design field to produce higher power and larger heat generating components (as much as 50 watts in the case of recent pin array microprocessors) leads to an enormous generation of heat that must be dissipated. Without effective heat dissipation, the circuit would soon fail and its components might even suffer mechanical failure of their lead connections due to extreme differential expansion of the various materials of the component and board relative to each other. Thus, as shown in FIG. 1, very high thermal output components such as a power supply integrated circuit chip 28 were in the past often isolated on a heat sink circuit board 30 having a metallic or similar heat dissipating base 32. The power supply chip 28 is, thus, interconneted to the main logic board 20 by wire leads 34.

Even in situations involving the use of lower heat generating components, it is desirable to incorporate power supply chips on the same board as the complex logic and analog components. Since power supplies, themselves, generate a large quantity of heat, a board that adequately dissipates heat must be provided for this multi-layer application. The conventional epoxy glass and fiber-type electrically insulating circuit board cannot fulfill this requirement.

### Summary of the Invention

It is therefore an object of the present invention to provide a multi-layer circuit board with high heat dissipating characteristics.

It is another object of this invention to provide a multi-layer circuit board that allows the incorporation of a power supply component with multi-lead logic and analog components on the same board.

It is another object of this invention to provide a multi-layer circuit board that may be constructed with relative ease in a variety of configurations.

It is yet another object of this invention to provide a multi-layer circuit board that enables formation of a large number of connecting planes and mounting of a large number of multi-connection components upon a single relatively compact board with reliable performance thereof.

A multi-layer heat dissipating circuit board for mounting a plurality of heat generating circuit chips thereon according to this invention provides a base plate composed preferably of aluminum or other highly thermally conductive material. The base plate has disposed thereover a bottom insulating layer that prevents electrical contact between the base plate and any upwardly disposed layers of circuitry. The insulating layer may be formed preferably of a thermally conductive dielectric epoxy. Positioned over this insulating layer are a plurality of alternating layers of electrically conductive strips and selectively disposed intervening insulating layers such that predetermined strips in each conducting layer are separated from those in other conductive layers by means of the insulation while predetermined locations between conductive strips in different layers are exposed to each other allowing electrical contact therebetween. Some of the conductive strips may be formed using a conductive ink such as silver filled epoxy while insulating layers may be composed of a dielectric thermally conductive epoxy. Both insulating and conductive layers may be applied by means of silk screening. A bottom-most layer of conductive strips may comprise etched copper foil that is applied to the bottom layer of insulation using a thermally conductive adhesive. Similarly, mounting pads for each of the circuit chips may be formed in this copper foil layer.

### Brief Description of the Drawings

The foregoing objects and advantages will become more clear with reference to the following detailed description of a preferred embodiment and drawings in which:
FIG. 1 is a somewhat schematic perspective view of a circuit board arrangement according to the prior art;
FIG. 2 is a partially broken view of a multi-layer heat dissipating circuit board according to this invention;
FIG. 3 is a top view of the first conductive layer of the circuit board of FIG. 2;
FIG. 4 is a cross-sectional side view along line 4-4 of FIG. 3;
FIG. 5 is a top view of the second insulating layer of the circuit board of FIG. 2;
FIG. 6 is a cross-sectional side view along line 6-6 of the circuit board of FIG. 5;
FIG. 7 is a top view of the third conductive layer of the circuit board of FIG. 2;
FIG. 8 is a cross-sectional side view along line 8-8 of the circuit board of FIG. 7;
FIG. 9 is a top view of the circuit board of FIG. 2 including circuit chips attached thereto;
FIG. 10 is a cross-sectional side view along line 10-10 of the circuit board of FIG. 9; and
FIG. 11 is a cross-sectional side view along line 11-11 of the circuit board of FIG. 9.

### Detailed Description of the Preferred Embodiment

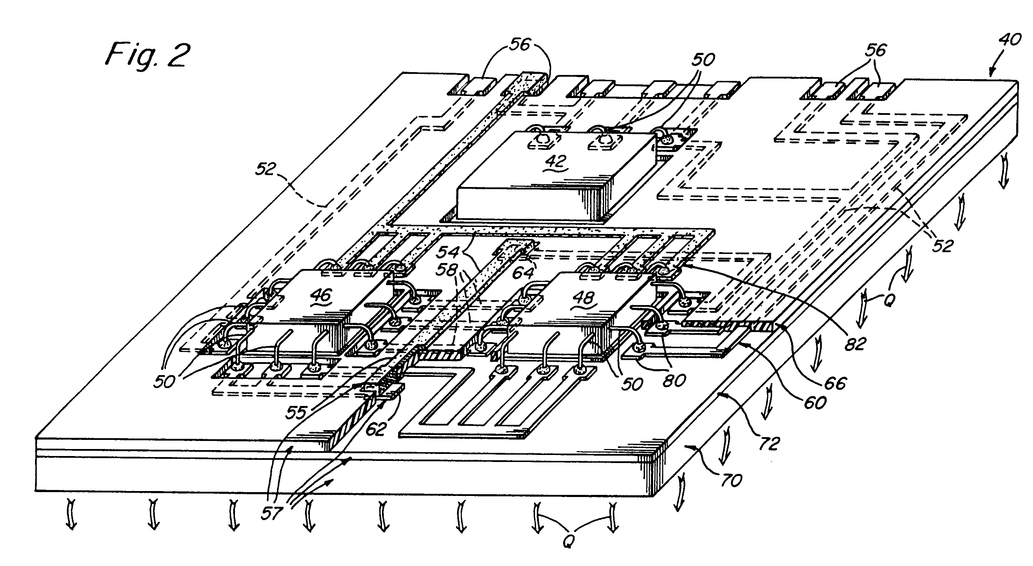

A multi-layered/multi-plane circuit board having both power supply and logic integrated circuits as illustrated in FIG. 2. The circuit according to this embodiment is relatively simple in comparison to the highly complex circuit designs contemplated according to this invention. The circuit board 40 specifically includes one power supply chip 42 and two twelve-pin logic chips, Logic I 46 and Logic II 48. The wire leads 50 of each of the chips 42, 46, 48 are connected together variously by means of conductive strips 52, 54 or leads that carry electrical current between these leads 50. External lead contacts 56 are further provided upon an edge of the circuit board 40 for connecting with exterior components via plugs, solder joints and the like. The conductive strips 52, 54 are connected variously to these contacts 56.

In order to avoid the need for jumper wires 26 as depicted in FIG. 1, the circuit board 40 is formed in a plurality of planes 57 of alternating insulating and conducting materials. The particular materials utilized and their method application will be discussed further below, but generally, multiple layers of strips are employed in locations upon a circuit board where a conductive strip must crossone or more conductive strips on the same plane without the crossing strips coming into contact, as, for example, in the bridge 55 of FIG. 2. In this embodiment, one set of parallel conductive strips 58 is positioned upon a lower layer 60. The bridging strip 55 must cross this set. Therefore, bridging points 62, 64 aside the set of strips 58 are established upon the lower layer 60 for the crossing the set of strips. An upper layer of insulation 66 is, thus, applied over the lower layer 60 of conductive strips except for the region proximate each of the bridging points 62, 64 which remain exposed.

A column of conductive material fills the gaps in the insulation over each of the bridging points to bring the conductive material level at these points up to the level of the surface of the insulating layer 66. The bridging strip 55 on the surface of the insulating layer 66 is formed between the two filled bridging points 62, 64. The bridging strip 55 is thus, physically and electrically separated from the lower set of crossed strips 58 by means of the intervening insulating layer 66.

The multi-layer circuit board 40, according to this embodiment, is designed for closely fit mounting of a plurality of integrated circuit chips and components thereon. In particular, the board 40 may accommodate, in combination with the logic chips 46, 48, a power supply chip 42. As such, a significant quantity of heat is generated during normal operation of the board's circuit components. Thus, the multi-plane board of this invention includes a base plate 70 comprising metallic or other highly thermally conductive material. Other types of materials haing high thermal conductivity include ceramic substrates, pure metals and polymeric systems such as polyimides. In this embodiment, an aluminum alloy plate of approximately 1/16˝ thickness is utilized. The plate 70 should generally remain uncovered upon a face opposite the circuitry so that heat Q may be freely dissipated to the environment by means of air convection and radiation. Note that corrugation or other texturing may be placed upon this surface to further increase conductivity. The base plate side proximate the circuitry should, conversely, be covered with a bottom layer 72 of dielectric insulating material. Since the plate 70 of this embodiment is metallic and electrically conductive, the layer 72 should be sufficiently thick to isolate any upwardly disposed circuitry from the metallic surface of the base plate 70. A suitable dielectric layer may be obtained by applying a one or two component dielectric thick film epoxy such as ME 933-53 or ME 51-46, respectively, by the Emerson & Cumming, Inc. Alternatively, an insulating layer may be formed using a polyimide, urethane, silicone or polyester compound among others. A layer of from 3 to 10 mils should suffice in most circumstances to prevent electrical contact of the base with upper layers.

It is important that the epoxy utilized possess sufficient thermal conductivity to assure adequate transmission of generated heat from the upper circuit layers to the base plate. Otherwise, excess heat retained by the upper layers may cause damage to the circuit leads and semi-conductor components.

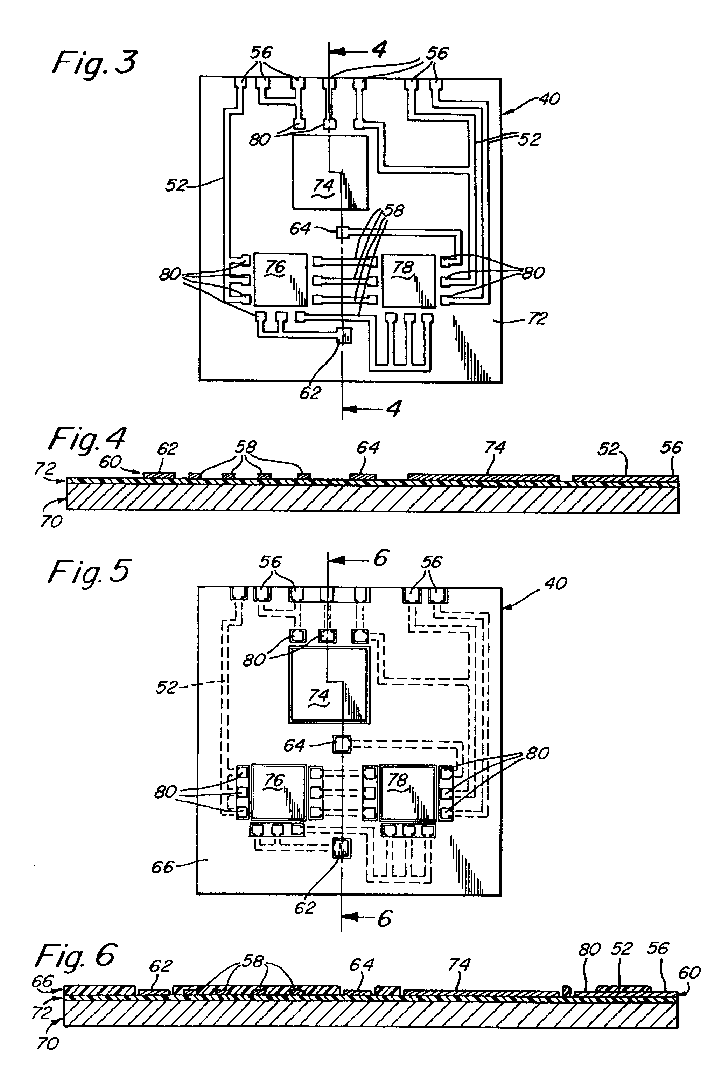

Above the insulating epoxy bottom layer is deposited an initial conducting layer 60. The deposition of this layer is shown, particularly, in FIGS. 3-4. Note that printing or silk screening is the preferred method of deposition in this embodiment. It may be used for the leads and insulator and even for certain components such as resistors. A variety of conductive materials may be utilized for the first layer. However, general practice has developed a preference for a solid copper foil layer that is adhered to the insulating material using, for example, an aluminum oxide based thermally conductive epoxy in a 3 mil layer. The copper foil is subsequently masked to form a lead pattern. The board surface is then exposed to acid that dissolves unmasked copper such that the board is selectively etched to remove all copper materialexcept the desired lead pattern. Such a lead pattern is particularly illustrated in FIG. 3 and corresponds to the lower layer conductive strips 52 (shown in phantom) of FIG. 2.

The conductive lead pattern includes pads 74, 76 and 78 respectively, for mounting the power supply 42 and each of the logic chips 46, 48. The pads 74, 76, 78 of copper foil in this embodiment provide excellent heat sink qualities for directing thermal energy from the chip to the base plate with a minimum dispersion within the upper board layers and they also facilitate firm mounting of the chips to the board. Chips may, in particular, be mounted by means of solder or adhesives in a manner described further below.

Around each chip mounting pad 74, 76, 78 are positioned a plurality of contact pads 80 for interconnection of chip wire leads to the desired conductive strips. As discussed above, the layout of conductive strips also includes a pair of bridging points 62, 64 that take the form of contact pads, in this embodiment. The electrical circuit connection between bridging points 62, 64 is, of course, broken on the lower conductive layer 60 of FIG. 3.

After forming the lower layer 60 of conductive strips, it is subsequently covered, in select locations, with an upper layer 66 of insulating dielectric thermally conductive epoxy as depicted in FIGS. 5-6. The object of the application of the upper insulating layer 66 is to cover all parts of the lower conductive layer 60 except the connection points that are to be accessed by subsequently applied upper disposed conductive layers and component leads. Each mounting pad 74, 76, 78 is also left uncovered since it is desirable to place the heat generating chips as close as possible to the base plate. Additionally, each lead contact pad 80 on this layer generally remains uncovered so that a corresponding chip lead wire may be attached thereto. Bridging points 62, 64 are also left uncovered to be electrically connected in the next conductive layer.

The application of the upper insulating layer 66, according to this embodiment, may be performed via a variety of methods. Silk screening of the epoxy insulating material over selected areas of lower layer strips 52 provides a highly accurate and precise application method of alternatively covering and exposing sections of leads according to this embodiment. Alternatively, vapor deposition (sputtering) or electro deposition, in the case of conductive strips, or other suitable coating methods may be utilized.

Following deposition of the upper insulating layer 66 to selected locations of the lower conductive layer 60, an upper conductive layer 82 of leads or strips 54 is then deposited thereover. While it is possible to apply the second conductive layer 82 using solid copper sheet or foil in combination with masking of exposed contact points from the first layer and then etching the sheet to obtain the appropriate strip configuration, it is not generally practical to do so. Rather, a polymer base thick film conductive compound, including various forms of conductive "ink", such as Emerson & Cumming, Inc. silver-filled epoxy C 933-34 is utilized to lay down strips 54 at selected locations. An epoxy of such type, is then hardened using elevated temperature curing to develop optimal properties.

The conductive epoxy leads 54 of the upper conductive layer 82 may be disposed wholly upon the surface of the upper insulating layer 66, or may partially impinge upon and contact the lower conductive layer 60 through exposed locations in the insulation 66 therebetween. Such contact occurs, for example, at the two bridging points 62, 64. Since the conductive compound or ink is a polymer thick film (as opposed to an inorganic such as alumina), it tends to flow into crevices and fill them. As such, the ink may be built up to fill the columns around exposed points of the lower conductive layer 60, thus, bringing the upper conductive layer 82 up to a level that is even with or above the level of the upper insulating layer 66. Alternatively, solder or similar gap filling conductive compositions may be utilized in a separate application step to build a conductive column between layers. Since the insulating layers between conductive layers are only a few mils thick, minimal gap filling is necessary at exposed points which facilitates silk screening techniques.

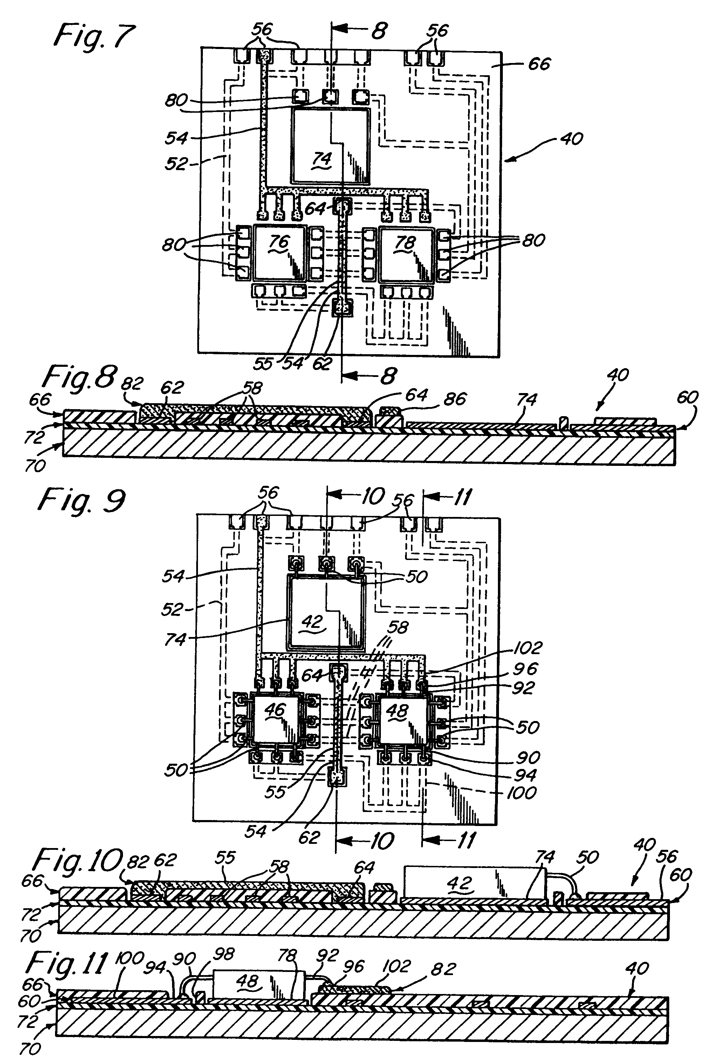

While silk screening is relatively precise in its deposition of material, closely spaced lines of conductive epoxy may still necessitate masking of contacts in lower layers. One such point where masking may be required is the bridging point 64 (FIG. 8), to prevent its inadvertent connection with the adjoining strip 86 of conductive epoxy during application of additional conductive material. Such masking could be removed by an appropriate solvent following the deposition of the conductive layer to reexpose these leads for further connections.

While the above-described embodiment shows only two alternating layers of conductive strips with a layer of insulation therebetween, the steps described in FIGS. 3-8 may be repeated by selectively depositing additional layers of insulation and conductive strip material, one over the other, until rather large lattices of interconnected layered strips are created. Columns for connecting one layer to another, or several layers together, with connected layers in both adjacent and non-adjacent positions relative to each other, may be formed at any location upon the surface of a circuit board. Connections of such type are performed by leaving a contact point of a lower layer exposed while building up successive layers that continue to expose the contact point and then finally forming a conductive column to an upper lead from the contact point through the open "hole" in the layers therebetween. Note that a final insulating layer may then be applied over all the layers so that only the remaining desired contact points are exposed. One may even apply an upper ground plane to the top layer of the board.

FIG. 9 illustrates the final attachment of the circuit chips 42, 46, 48 to the board with wire leads 50 attached to the exposed contact points of the two-conductive layer circuit board embodiment of FIG. 2. While an insulating layer, as discussed above, may be applied to the upper conductive strips, leaving only the strip contact pads, and edge plug contact points 55 exposed, such a layer has been omitted in this example for added clarity.

Each chip wire lead 50 is attached by means of solder or a similar electrically conductive adhesive to its respective mounting pad 74, 76, 78. Since the mounting pads have remained exposed, the chips 42, 46, 48 transmit heat almost directly to the base plate 70. The wire leads 50 of the chips are then attached to each respective contact pad 80 (FIG. 7) by means of an electrically conductive adhesive or solder. Note that the chip wire leads 90, 92 may be attached to contact pads 94 and 96 respectively on strips of differing conductive layers 60 and 82 respectively. For example, FIG. 11 illustrates a left lead 90 attached through a hole 98 in the upper layer of insulation 66 to lower layer conductive strip 100 while a right lead 92 is attached to an upper conductive layer strip 102. Again, further upperwardly disposed layers of insulation and conductive strips may be applied over the illustrated layers according to this invention and upper disposed leads may be positioned variously through a given number of layers to electrically connect to the appropriate lower strip.

It should be understood that the preceding is merely a detailed description of a preferred embodiment. It should be apparent to those skilled in the art that various modifications and equivalents may be made without departing from the spirit or scope of the invention. The preceding description is meant to be taken only by way of example and to describe only a preferred embodiment and not to otherwise limit the scope of the invention.

## Claims

1. A multi-layer heat dissipating circuit board comprising:
a thermally conductive base;
an electrically insulating thermally conductive base layer disposed over one surface of the base; and
a plurality of alternating layers of electrically conductive circuit leads and selectively disposed insulation positioned upon the base layer, predetermined portions of the circuit leads in predetermined ones of the layers being accessible from others of the layers.

2. A circuit board according to claim 1, wherein the electrically conductive circuit leads of one layer are accessible to another layer of leads at at least one predetermined point through the intervening insulating layer.

3. A circuit board as set forth in claim 1 wherein the base is a metallic plate, preferably an aluminum alloy plate.

4. A circuit board as set forth in claim 3 further comprising means for mounting at least one semi-conductor chip, the means for mounting being attached to the insulating bottom layer.

5. A circuit board as set forth in claim 4 wherein the circuit leads in a layer closest to the insulating bottom layer comprise metallic foil.

6. A circuit board as set forth in claim 5 wherein at least one said intervening insulating layer comprises dielectric thermally conductive polymer.

7. A circuit board as set forth in claim 6 wherein at least one of the layers of conductive circuit leads comprises an electrically conductive polymer compound, preferably an electrically conductive epoxy, more preferably a conductive epoxy which includes a silver based metal.

8. A circuit board as set forth in any one of claims 1 to 7, wherein predetermined leads having spaced apart points in one layer are electrically connected by a bridging lead attached to each of the points and passing through at least one intervening insulating layer and disposed substantially within another electrically conductive layer, the bridging lead optionally comprising an electrically conductive polymer compound disposed upon the face surface of an adjacent intervening insulating layer.

9. A circuit board as set forth in any one of claims 1 to 8, further comprising means for mounting a power supply integrated circuit, the means for mounting optionally including a mounting pad substantially sized to the shape of the power supply integrated circuit, the pad being attached to the insulating bottom layer, the mounting preferably comprising a metallic foil, and the mounting pad optionally including adhesive for attachment to the insulating bottom layer.

10. A circuit board as set forth in any one of claims 1 to 9, wherein at least some of the electrically conductive leads comprise electrically conductive ink.

11. A circuit board as set forth in claim 10, wherein at least some of the layers of insulation comprise thick film thermally conductive dielectric compound.

12. A circuit board as set forth in any one of claims 1 to 11, further comprising means for mounting a power supply integrated circuit and/or at least one logic integrated circuit to the base layer.

13. A circuit board as set forth in claim 12, wherein the electrically conductive ink and/or the insulation comprise an epoxy compound, optionally a one component thermally hardened material.

14. A circuit board as set forth in claim 12 or 13, wherein each of the means for mounting the logic integrated circuit, the means for mounting the power supply and a layer of electrically conductive leads closest the base layer are etched cooper foil attached to the base layer by adhesive.

15. A method for constructing a multi-layer heat dissipating circuit board comprising:
providing an electrically insulated thermally conductive base having a surface suitable for placement of circuit leads thereon;
disposing, upon the surface, at least two upwardly positioned layers of electrically conductive circuit leads and at least one selectively disposed insulating layer between the layers of circuit leads, the insulating layer being positioned so that predetermined points between layers of electrically conductive leads are exposed allowing electrical connection at the points between leads in different layers.

16. A method as set forth in claim 15 further comprising forming spaced apart contact points on electrically conductive leads in one of the layers and disposing a connecting lead therebetween that extends from the contact points into another electrically conductive layer through at least one insulating layer therebetween.

17. A method as set forth in claim 15 or 16, wherein the step of disposing electrically conductive leads includes depositing of electrically conductive ink upon the surface over an insulating layer, optionally by filling predetermined locations having uninsulated exposed leads of another layer of electrically conductive leads to electrically connect leads of different layers.

18. A method as set forth in claim 17, wherein each of the steps of depositing and filling electrically conductive ink comprise silk screening of electrically conductive ink upon the surface.

19. A method as set forth in any one of claims 15 to 18, wherein the step of disposing an insulating layer between layers of electrically conductive leads includes selectively depositing a thermally conductive insulating compound over a lower layer of electrically conductive leads, optionally by silk screening of the insulating compound in a predetermined pattern.

20. A method as set forth in any one of claims 15 to 19 further comprising disposing three or more alternating layers of electrically conductive leads and selectively disposed insulating layer between each of the layers of electrically conductive leads, each insulating layer being arranged so as to expose predetermined portions of leads in a layer thereof to allow electrical connection with leads in other layers.

21. A method as set forth in any one of claims 15 to 20, wherein the step of providing includes constructing a metallic plate and coating one surface thereof with a bottom insulating layer, and optionally the step of disposing includes etching a layer of electrically conductive leads closest the bottom insulating layer from metallic foil applied to the bottom insulating layer by adhesive.
